(19) Europäisches Patentamt
European Patent Office
Office européen des brevets

(11) EP 2 950 449 A1

(12) **EUROPEAN PATENT APPLICATION**

(43) Date of publication:
**02.12.2015 Bulletin 2015/49**

(51) Int Cl.:
***H03H 7/25*** *(2006.01)*

(21) Application number: **14305800.6**

(22) Date of filing: **28.05.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Alcatel Lucent**
**92100 Boulogne-Billancourt (FR)**

(72) Inventor: **Bulja, Senad**
**Dublin, 15 (IE)**

(74) Representative: **Leppard, Andrew John et al**
**Script IP Limited**
**Turnpike House**
**18 Bridge Street**
**Frome**
**Somerset BA11 1BB (GB)**

Remarks:
Amended claims in accordance with Rule 137(2) EPC.

# (54) Attenuator

(57) An attenuator and an attenuating method are disclosed. The attenuator comprises an input (10) operable to receive an input signal to be attenuated and a 3-dB coupler (20) coupled with said input (10), the output (30) of the coupler providing an attenuated input signal. The attenuator further comprises a pair of reflective loads (40) coupled with said 3-dB coupler (20), each reflective load (40) comprising a first impedance network (70+80) arranged in parallel with a second impedance network (50+60), both impedance networks being connected to ground. Said first impedance network and said second impedance network comprise each an impedance device (70, 50) connected in series with a diode (80, 60). This provides for an attenuator having increased dynamic range but acceptable insertion losses. Instead a 3-dB couple, a circulator could be used.

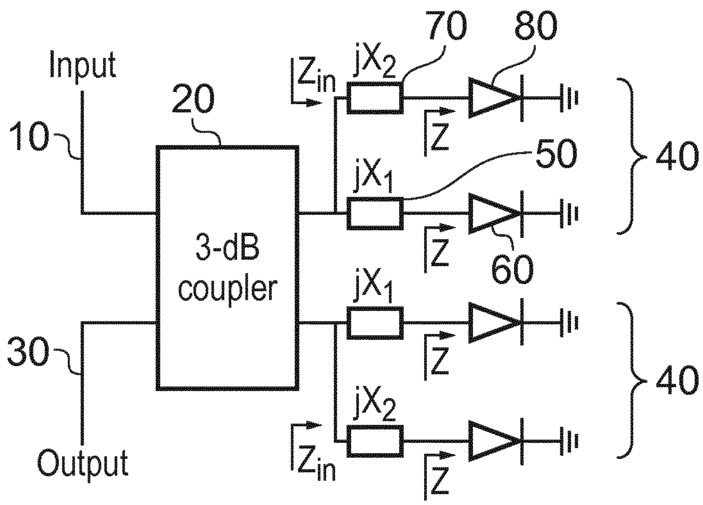


High dynamic range attenuator

FIG. 2

EP 2 950 449 A1

## Description

### FIELD OF THE INVENTION

The present invention relates to an attenuator and a method.

### BACKGROUND

Attenuators are known. In particular, RF attenuators are widely used in radar systems, point to point radio, smart antennas and in radio frequency (RF) signal cancellation. The choice of antenna for a particular application is influenced by many factors, such as the required dynamic range, insertion losses, power consumption, linearity and power handling capabilities. For lower power handling capabilities and lower costs, PIN diodes or field effect transistors (FETs) are usually used to achieve such attenuation. These devices are well suited for use as attenuators because the resistance of a PIN diode is direct current (DC) current controlled and so the higher the current through the PIN diode, the lower the resistance. The resistance of FET based attenuators is DC voltage controlled, typically in the order of a few volts, which depends on the breakdown voltage of the gate-source junction.

Although these arrangements provide for functional attenuators, the performance of such attenuators may be less than optimal in some circumstances.

Accordingly, it is desired to provide an improved attenuator.

### SUMMARY

According to a first aspect, there is provided an attenuator, comprising: an input operable to receive an input signal to be attenuated; a coupling device coupled with the input and with an output providing an attenuated input signal; and a pair of reflective loads coupled with the coupling device to receive the input signal, each reflective load comprising a first impedance network arranged in parallel with a second impedance network, the first impedance network and the second impedance network each comprising an impedance device and a variable impedance device.

The first aspect recognises that a radio frequency (RF) device of great importance in telecommunications is an attenuator. It is widely used in radar systems, point-to-point radio, smart antennas and RF signal cancellation, as well as other applications. The choice of the attenuator for a particular application is influenced by many factors; for example, the amount of the dynamic range, the insertion losses, power consumption, linearity and power handling capability. For lower power handling capabilities and lower costs the variation of attenuation is usually achieved using either PIN diodes or field effect transistors (FETs). These two elements are inherently suitable for variable attenuation devices, for the reasons that their resistance is controlled electrically. In particular: The resistance of the PIN diode is direct current (DC) current controlled, the higher the current through the PIN diode, the lower the resistance; The resistance of FET based attenuators is DC voltage controlled, typically in the order of a few volts (depending on the breakdown voltage of the gate-source junction). For reasons related to cost effectiveness, the reflective type topology attenuator is widely used, as illustrated in Figure 1 and either PIN diodes or FET transistors are used as elements to control the attenuation level. The device shown in Figure 1 consists of a 3-dB branch line coupler and PIN diodes in the circuit of the reflective loads. With equal validity, FETs could be used instead of PINs. Its operational principle is relatively straightforward; depending on the DC bias current through the PIN diodes, the circuit of the reflective load (PIN diodes) either absorbs or reflects the incident RF power. The reflection coefficient of the reflective loads, denoted by a variable impedance, Z, in Figure 1 can be expressed as:

$$\Gamma = \frac{Z - Z_0}{Z + Z_0} \quad \text{equation (1)}$$

where $Z_0$ is the characteristic impedance of the interconnecting microstrip line.

Assuming that the 3-dB coupler is ideal, the transmission coefficient of the attenuator of Figure 1 can now be expressed as:

$$\left|S_{21_single}\right| = \left|j\Gamma\right| = \frac{Z\text{-}Z_0}{Z+Z_0} \quad \text{equation (2)}$$

From equation (2) it can be inferred that RF power absorption occurs when the impedance of the PIN diodes has a real part and it is highest ($S_{21}$ = 0) when the PIN diode's impedance is purely real and equal to the terminating impedance of the 3-dB coupler, $Z_0$, (usually 50Ω). Ideally, in this case, the RF signal is infinitely attenuated. At the opposite end, all RF power is fully reflected ($S_{21}$ = 1)) from the loads when the PIN diode's impedance has no real part, i.e. Re(Z)=0. In this case, there is no signal attenuation.

For a reflection-type attenuator to be variable, the impedance of the PIN diode must be such that its impedance is resistive and varies between 0-50Ω. In practice, however, this is never achieved. The impedance of the PIN diode is never completely real, even when the PIN diode is in the die form, due to the constraints of current technologies. Also, like any other semiconductor device, a PIN diode exhibits parasitic effects due to the packaging (such as parasitic resistance, lead inductance, junction capacitance and package capacitance). All these effects influence the impedance dependence of the PIN diode on the bias current in a way that complete absorption and reflection of an RF signal is not possible. In this case, the parameters of importance in the design of PIN diode-based reflection attenuators are the dynamic range, i.e. the difference between the maximum and minimum attenuation between two bias current states and insertion loss.

The dynamic range is mainly influenced by the parasitic elements of the active device, namely parasitic resistance, lead inductance and parasitic capacitances. These parameters are, ultimately, technology dependent since a more expensive semiconductor technology and a better encapsulation of the bare die will inevitably yield lower values of the parasitic elements. Nevertheless, regardless of the technology, a single active device per reflective load is unlikely to yield a dynamic range better than 20-30dB. For a better dynamic range, different attenuator topologies need to be sought; however, these solutions are unlikely to be cost effective.

Insertion loss is, like the dynamic range, dependent on the parasitic elements of the active device; however, the parameter of most importance is the parasitic resistance. This parameter is mainly influenced by the semiconductor technology used for the active device. Nevertheless, regardless of the technology, the parasitic resistance is always present, and, in the reflective type attenuator form of Figure 1, the insertion loss is unlikely be lower than 1dB.

For the purpose of the lower gigahertz range applications (4G, GSM and UMTS, amongst others), attenuators with an insertion loss in the region of about 1dB are generally considered adequate; however, a greater importance is placed upon the achievement of greater dynamic range than that offered at present. As such, the first aspect recognises that the realization of cost effective, moderate insertion loss (in the region of 1-1.5dB) and high dynamic range electrically controlled attenuators is desirable.

As mentioned above, existing arrangements are based on a PIN diode. A typical topology resembles the attenuator of Figure 1. The performance of this representative reflective-type attenuator shown in Table 1 below:

Table 1

| | |
|---|---|
| Frequency range (GHz) | 1.7 - 2 |
| Insertion loss (Ibias = 0mA) dB | 1.5 |
| Attenuation (Ibias = 3mA) dB | 22.5 |

Even though a careful selection of the PIN diode can yield a higher dynamic range, this choice is ultimately limited by the choice of technology for the PIN diode. One way to increase the dynamic range would lie in the cascade connection of circuits of Figure 1, since the transmission coefficient of the overall connection becomes:

$$\left|S_{21_cascade}\right| = \left|S_{21_single}\right| \cdot \left|S_{21_single}\right| = \left|j\Gamma\right| \cdot \left|j\Gamma\right| = \frac{(Z-Z_0)(Z-Z_0)}{(Z+Z_0)(Z+Z_0)} \quad (3)$$

However, the first aspect recognises that this should be avoided, since the increase in the dynamic range would also lead to the increase of the insertion loss, due to the presence of an extra 3-dB coupler, and the extra microstrip lines connecting the two devices. For example, a cascade connection of two attenuators of Figure 1 will result in the doubling of the insertion loss and attenuation but, in view of the attenuator summarized in Table 1, this would lead to an insertion loss of 3dB (plus an additional insertion loss due to the interconnecting microstrip lines) and an attenuation of 45dB. However, in order for the attenuator to be useful, its insertion loss needs to be in the region of 1-1.5dB. Hence, the first aspect recognises that the cascade connection of attenuators needs to be avoided and there is a strong need for moderate insertion loss and high dynamic range attenuators which could be realized in the reflective type configuration, but using only one 3-dB coupler.

Accordingly, an attenuator is provided. The attenuator may comprise an input which receives an input signal for attenuation. A coupling device may be coupled with the input and also with an output. The output may provide an attenuated input signal as an output signal. The attenuator may also comprise a pair of reflective loads. The pair of reflective loads may be coupled with the coupling device. The pair of reflective loads may receive the input signal. Each of the reflective loads may have first and second impedance networks arranged in parallel with each other. The first and second impedance network may each have an impedance device together with a variable impedance device. In this way, an improved dynamic range attenuator is provided through the provision of the additional impedance network in the reflective loads. However, unlike the cascade connection mentioned above, this parallel arrangement provides this additional dynamic range without the associated increase in insertion losses. This provides for an attenuator having increased dynamic range but acceptable insertion losses.

In one embodiment, each reflective load is coupled at one end with the coupling device to receive the input signal and at another end with ground. Hence, each reflective load is both coupled with the coupling device and with ground.

In one embodiment, the first impedance network and the second impedance network each comprise the impedance device coupled with the coupling device to receive the input signal, the impedance device being coupled with the variable impedance device which is in turn coupled to ground. Accordingly, each impedance network is also coupled with the coupling device and with ground.

In one embodiment, the first impedance network comprises a series arrangement of a first impedance device and a first variable impedance device, and the second impedance network comprises a series arrangement of a second impedance device and a second variable impedance device. Accordingly, each impedance network has an impedance device and a variable impedance device arranged in series.

In one embodiment, the coupling device has a characteristic impedance Zo, the first and second variable impedance devices have an impedance Z, the first impedance device has an impedance jX1 and the second impedance device has an impedance jX2 determined in accordance with $Z = \pm X1 = \mp X2 = Z0$.

In one embodiment, the first impedance network arranged in parallel with the second impedance network together form a second-order load and each reflective load comprises a parallel arrangement of N' number of the second-order loads, each in series with a further impedance device, where $N = 2^{\wedge\,(n-1)}$, $n \geq 1$. Accordingly, attenuators with additional orders may be provided by adding further impedance networks to each reflective load.

In one embodiment, a first second-order load is provided in series with a first further impedance device having an impedance jX1 and a second second-order load is provided in series with a second further impedance device having an impedance jX2 determined in accordance with $Z = \pm X1 = \mp TX2 = Z0$.

In one embodiment, the attenuator comprises a compensating impedance device provided between each impedance device and variable impedance device. Accordingly, a device which compensates for parasitic inductance and/ or capacitance may be provided.

In one embodiment, the variable impedance device has an inductance Ls and the compensating impedance device comprises a capacitor having a capacitance Ccomp determined in accordance with $\omega Ls = \frac{1}{\omega Ccomp}$, where $\omega$ corresponds to an operating frequency of the input signal.

In one embodiment, the coupling device comprises one of a 3dB coupler and a circulator.

In one embodiment, the impedance device comprises a lumped impedance device.

In one embodiment, the variable impedance device comprises one of a transistor and a diode.

In one embodiment, the variable impedance device comprises one of a field effect transistor and a PIN diode.

According to a second aspect, there is provided a method, comprising: providing an input operable to receive an input signal to be attenuated; providing a coupling device coupled with the input and with an output providing an attenuated input signal; and providing a pair of reflective loads coupled with the coupling device to receive the input signal, each reflective load comprising a first impedance network arranged in parallel with a second impedance network, the first impedance network and the second impedance network each comprising an impedance device and a variable impedance device.

In one embodiment, each reflective load is coupled at one end with the coupling device to receive the input signal and at another end with ground.

In one embodiment, the first impedance network and the second impedance network each comprise the impedance device coupled with the coupling device to receive the input signal, the impedance device being coupled with the variable impedance device which is in turn coupled to ground.

In one embodiment, the first impedance network comprises a series arrangement of a first impedance device and a first variable impedance device, and the second impedance network comprises a series arrangement of a second impedance device and a second variable impedance device.

In one embodiment, the coupling device has a characteristic impedance Zo, the first and second variable impedance devices have an impedance Z, the first impedance device has an impedance jX1 and the second impedance device has an impedance jX2 determined in accordance with $Z = \pm X1 = \mp X2 = Z0$.

In one embodiment, the first impedance network arranged in parallel with the second impedance network together form a second-order load and each reflective load comprises a parallel arrangement of N' number of the second-order loads, each in series with a further impedance device, where $N = 2^{\wedge (n-1)}$, $n \geq 1$.

In one embodiment, a first second-order load is provided in series with a first further impedance device having an impedance jX1 and a second second-order load is provided in series with a second further impedance device having an impedance jX2 determined in accordance with $Z = \pm X1 = \mp X2 = Z0$.

In one embodiment, the method comprises providing a compensating impedance device provided between each impedance device and variable impedance device.

In one embodiment, the variable impedance device has an inductance Ls and the compensating impedance device comprises a capacitor having a capacitance Ccomp determined in accordance with $\omega Ls = \frac{1}{\omega Ccomp}$, where $\omega$ corresponds to an operating frequency of the input signal.

In one embodiment, the coupling device comprises one of a 3dB coupler and a circulator.

In one embodiment, the impedance device comprises a lumped impedance device.

In one embodiment, the variable impedance device comprises one of a transistor and a diode.

In one embodiment, the variable impedance device comprises one of a field effect transistor and a PIN diode.

Further particular and preferred aspects are set out in the accompanying independent and dependent claims. Features of the dependent claims may be combined with features of the independent claims as appropriate, and in combinations other than those explicitly set out in the claims.

Where an apparatus feature is described as being operable to provide a function, it will be appreciated that this includes an apparatus feature which provides that function or which is adapted or configured to provide that function.

## BRIEF DESCRIPTION OF THE DRAWINGS

Embodiments of the present invention will now be described further, with reference to the accompanying drawings, in which:

Figure 1 illustrates an attenuator;
Figure 2 illustrates an attenuator according to one embodiment;
Figure 3 illustrates an equivalent circuit of a PIN diode;
Figure 4 shows the variation of attenuation of the attenuator of Figure 1 (junction resistance varies in steps of 5 Ω); and
Figure 5 shows the variation of attenuation of the attenuator of Figure 2 (junction resistance varies in steps of 5 Ω).

## DESCRIPTION OF THE EMBODIMENTS

Before discussing the embodiments in any more detail, first an overview will be provided. Embodiments provide an arrangement which provides for an improved performance attenuator which is achieved using a coupling device coupled with a pair of reflective loads, each reflective load having at least two impedance networks arranged in parallel. The provision of the parallel arrangement of the impedance networks provides for improved dynamic range of the attenuator, whilst retaining essentially an unchanged insertion loss. In particular, embodiments provide a high dynamic range variable attenuator which is of the reflective type for cost effectiveness. In order to provide for further cost reduction and to maintain low insertion losses, the number of 3-dB couplers needs to be kept to a minimum and embodiments utilise just one 3-dB coupler.

### Example Configuration

Figure 2 illustrates a high dynamic range attenuator according to one embodiment. Although this embodiment utilises PIN diodes as the active element, it will be appreciated that field effect transistors (FETs) may equally be utilised and achieve similar results. The arrangement shown in Figure 2 provides a reflective type attenuator which a minimised number of 3-dB couplers.

An input signal is provided over the path 10 coupled with an input port of the 3-dB coupler 20. The attenuated output signal is provided over the path 30 coupled with an output port of the 3-dB coupler 20. Also coupled to the 3-dB

coupler 20 are a pair of reflective loads 40. Each reflective load 40 comprises a parallel arrangement of two networks, each comprising a lumped element in series with a PIN diode. In particular, a first network comprises a lumped element 50 in series with a PIN diode 60, whilst a second network comprises a lumped element 70 in series with a PIN diode 80. The lumped elements 50, 70 are coupled in parallel with one port of the 3-dB coupler 20 whilst the PIN diodes 60, 80 are each coupled at one end to the ground. Hence, this arrangement provides two PIN diodes per load, which provides for the possible doubling of the dynamic range.

The performance of the attenuator is optimised by ensuring suitable characteristics for the lumped elements 50, 70, which have impedances X1, X2, respectively. Selecting suitable values for X1 and X2 allows the near doubling of the dynamic range of the attenuator using only one 3-dB coupler. It will be appreciated that since the doubling of the dynamic range is achieved using only one 3-dB coupler, the insertion loss of the circuit is not doubled, but is instead increased by only a small amount due to the presence of an extra PIN diode per load.

<u>Impedance Selection</u>

The reflection coefficient of the reflective loads of Figure 2, can be written as:

$$\Gamma = \frac{Z_{in} - Z_0}{Z_{in} + Z_0} \quad \text{equation (3)}$$

where $Z_{in}$ and $Z_0$ stand for the input impedance of the reflective loads and for the characteristic impedance of the interconnecting microstrip lines, respectively. The input impedance, $Z_{in}$, of each reflective load in Figure 2 can be written as:

$$Z_{in} = \frac{2Z^3 - 2ZX_1X_2 + Z(X_1 + X_2)^2}{4Z^2 + (X_1 + X_2)^2} + j\left[\frac{(X_1 + X_2)(X_1X_2 + Z^2)}{4Z^2 + (X_1 + X_2)^2}\right] \quad \text{equation (4)}$$

Here, $X_1$ and $X_2$ represent the lumped elements of Figure 2. First, it is necessary to impose the condition that the imaginary part of the input impedance is equal to zero, so that the input impedance, $Z_{in}$, is purely real. Solving equation (4) for $Im(Z_{in}) = 0$ yields the following relationship:

$$Z^2 = -X_1X_2 \text{ or } X_1 = -X_2 \quad \text{equation (5)}$$

Using the latter substitution, since it yields a reduced form of the real part of the input impedance, one obtains:

$$\Gamma = \frac{Z_{in} - Z_0}{Z_{in} + Z_0} \quad \frac{Z^2 + Z(-2Z_0) + X_1^2}{Z^2 + Z(2Z_0) + X_1^2} \quad \text{equation (6)}$$

In order for the circuit of Figure 2 to achieve a two times greater attenuation range than that offered by the circuit of Figure 1, its reflection coefficient given by equation (6) needs to be able to be presented in the form of:

$$\Gamma = \frac{(Z - Z_0)(Z - Z_0)}{(Z + Z_0)(Z + Z_0)} \quad \text{equation (7)}$$

since this configuration corresponds to equation (3), but needs to be achieved using only one 3-dB coupler. Therefore,

appropriate conditions need to be imposed on equation (6) so as to obtain the values for $X_1$ and $X_2$ which will yield equation (7).

By imposing that $\Gamma = 0$, in equation (6) one obtains a solution in Z :

$$Z_{1,2} = \frac{2Z_0 \pm \sqrt{4Z_0^2 - 4X_1^2}}{2} \quad \text{equation (8)}$$

The necessary condition for doubling the dynamic range is achieved by requiring that discriminant of equation (8) is equal to zero, yielding the value for the lumped element $X_1$, i.e. $X_1 = Z_0$. Once this condition is satisfied, a double zero is achieved at:

$$Z_{1,2} = Z_0 \quad \text{equation (9)}$$

And equation (6) can be re-written as:

$$\Gamma = \frac{(Z - Z_0)(Z - Z_0)}{(Z + Z_0)(Z + Z_0)} \quad \text{equation (10)}$$

which is identical to equation (7). The value for $X_2$ is obtained using equation (5), to yield a complete set:

$$Z = \pm X_1 = \mp X_2 = Z_0 \quad \text{equation (11)}$$

i.e. doubling of equation (1) is achieved without the replication of circuits of Figure 1. This infers that the dynamic range is doubled without doubling the insertion loss, since there is no insertion loss due to the presence of a second 3-dB coupler. Equation (11) satisfies the two conditions stated earlier. In this way one obtains a variable attenuator solution which satisfies two usually contradicting requirements - cost effectiveness and better performance.

If the circuit of Figure 1 is denoted as a first order attenuator (since it uses one PIN diode per reflective load), and the circuit of Figure 2 as a second order since it uses two PIN diodes per reflective load, higher order attenuators can be formed in a similar way presented above, where the allowed orders of the attenuators are determined in the binary exponential fashion. For example, if $R_n$ is identified as the order of the attenuator, the allowed orders of the attenuators are:

$$R_n = 2^{n-1}, \ n \geq 1 \quad \text{equation (12)}$$

Therefore, the first few allowed orders of attenuators formed in this way are: 1, 2, 4, 8 and so on. The order of the attenuator indicates the amount of increase of its dynamic range. For example, the second order attenuator has a dynamic range that is two times greater than its single order counterpart, and the fourth order attenuator has a dynamic range that is four times greater that its single order counterpart.

<u>Example Performance</u>

Figure 3 illustrates the equivalent circuit of a PIN diode. In this figure, $L_S$ is the parasitic lead inductance, $R_S$ is the parasitic resistance, $C_P$ is the parasitic package capacitance, $C_j$ is the parasitic junction capacitance, and $R_J$ is variable junction capacitance. Typical values of the parasitic elements of the PIN diode are: $L_S$=2nH, $R_S$=1.5Ω, $C_P$=0.08pF, $C_j$=0.12pF while $R_J$ is the current dependent resistor and, ideally, its resistance changes from a perfect

open to a perfect short.

The PIN diode's equivalent circuit of Figure 3 was used to design two attenuators operating at a centre frequency of 2.5 GHz. However, in order to compensate for the large lead inductance ($L_S$=2nH) of the PIN diode of Figure 3, a compensating capacitor was added in series with the PIN diode, $C_{COMP}$, obtained using the following relationship

$$\omega L_S = \frac{1}{\omega C_{COMP}}.$$

The first attenuator is a simple, single PIN diode per load design of Figure 1, while the second is the design whose topology is given in Figure. 2. A 3-dB coupler used in the simulations is assumed to have an insertion loss of 0.3 dB (a realistic assumption) and is made to operate in the frequency of 2.3 GHz to 2.7 GHz. The values of the lumped elements, $X_1$ and $X_2$ needed for the attenuator design are obtained using equation (11) to yield $C_1$=1.27 pF and $L_2$=3.16nH.

Figure 4 represents the variation of attenuation of the attenuator of Figure 1, realised with a PIN diode with the equivalent circuit of Figure 3. In the equivalent circuit of the PIN diode, it was assumed that the resistance of the junction resistor, $R_J$ varies from 0-50 Ω in steps of 5 Ω. In this case, the maximum insertion loss is about 1.1 dB, while maximum attenuation is about 28 dB and is achieved at 2.7 GHz. The dynamic range of this simple PIN diode-based attenuator varies from 17 dB at 2.3 GHz to 27 dB at 2.7 GHz.

The insertion loss of 1.1 dB of the attenuator of Figure 1 comprises the losses due to the 3-dB coupler and losses due to the finite resistance of the PIN diode. The insertion loss of a 3-dB coupler is stated to be 0.3 dB, however that applies to a signal travelling in one direction only. In the case of reflective-type configurations, the input signal travels through the 3-dB coupler, reaches the reflective loads and gets reflected off them to travel through the 3-dB coupler again and towards the output port. As such, since the signal travels two times through the 3-dB coupler, its insertion loss is:

$$\text{Loss}_{3_dB_coupler} = 2 \cdot 0.3\,\text{dB} = 0.6\,\text{dB}$$

while the remainder of the overall insertion loss:

$$\text{Loss}_{single_PIN_diode} = \text{Loss}_{single_PIN_attenuator} - \text{Loss}_{3_dB_coupler} = 0.5\,\text{dB}$$

is due to the finite resistance of the PIN diode.

Figure 5 depicts the attenuation performance of the high dynamic range attenuator of Figure 2 using the same PIN diode as the simple attenuator of Figure 1. The insertion loss of this attenuator is about 1.6 dB, which is in a good agreement with the prediction:

$$\text{Loss}_{double_PIN_attenuator} = 2 \cdot \text{Loss}_{single_PIN_diode} + \text{Loss}_{3_dB_coupler} = 1.6\,\text{dB}$$

The maximum attenuation of the attenuator is about 60dB. Its dynamic range varies from over 31 dB (at 2.3 GHz) to over 58 dB (at 2.6 GHz). It is worth noting that the insertion loss of the proposed attenuator, even though increased compared to the single PIN diode case attenuator, is not doubled (since it uses only one 3-dB coupler), while the dynamic range is almost doubled across the indicated frequency range. For comparison, in order to obtain the same dynamic range, a cascade connection of two attenuators of Figure 1 would be required. However, that would come at the expense of increased insertion loss. The theoretical prediction of the insertion loss in this case is: $2 \cdot LOSS_{single_PIN_attenuator}$ + microstrip line loss (0.3-0.4dB) = 2.2+(0.3-0.4) = 2.5-2.6dB which is about 1 dB higher than that of the arrangement of Figure 2.

To summarize, the main benefits of embodiments, therefore are: lower insertion loss compared to the case of two attenuators of Figure 1 connected in cascade, with the same dynamic range - this is due to the fact that only one 3-dB coupler is needed; and lower cost and smaller space required - again, this is due to the fact that only one coupler 3-dB is required which not only improves performance but also leads to a lower cost.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described

methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

The functions of the various elements shown in the Figures, including any functional blocks labelled as "processors" or "logic", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" or "logic" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown. The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

**1.** An attenuator, comprising:

an input operable to receive an input signal to be attenuated;
a coupling device coupled with said input and with an output providing an attenuated input signal; and
a pair of reflective loads coupled with said coupling device to receive said input signal, each reflective load comprising a first impedance network arranged in parallel with a second impedance network, said first impedance network and said second impedance network each comprising an impedance device and a variable impedance device.

**2.** The attenuator of claim 1, wherein each reflective load is coupled at one end with said coupling device to receive said input signal and at another end with ground.

**3.** The attenuator of claim 1 or 2, wherein said first impedance network and said second impedance network each comprise said impedance device coupled with said coupling device to receive said input signal, said impedance device being coupled with said variable impedance device which is in turn coupled to ground.

**4.** The attenuator of any preceding claim , wherein said first impedance network comprises a series arrangement of a first impedance device and a first variable impedance device, and said second impedance network comprises a series arrangement of a second impedance device and a second variable impedance device.

**5.** The attenuator of claim 4, wherein said coupling device has a characteristic impedance Zo, said first and second variable impedance devices have an impedance Z, said first impedance device has an impedance jX1 and said second impedance device has an impedance jX2 determined in accordance with $Z = \pm X1 = \mp TX2 = Z0$.

**6.** The attenuator of any preceding claim, wherein said first impedance network arranged in parallel with said second impedance network together form a second-order load and each reflective load comprises a parallel arrangement of N' number of said second-order loads, each in series with a further impedance device, where $N = 2^{\wedge(n-1)}$, $n \geq 1$.

**7.** The attenuator of any preceding claim, wherein a first second-order load is provided in series with a first further impedance device having an impedance jX1 and a second second-order load is provided in series with a second further impedance device having an impedance jX2 determined in accordance with $Z = \pm X1 = \mp TX2 = Z0$.

**8.** The attenuator of any preceding claim, comprising a compensating impedance device provided between each impedance device and variable impedance device.

**9.** The attenuator of any preceding claim, wherein said variable impedance device has an inductance Ls and said compensating impedance device comprises a capacitor having a capacitance Ccomp determined in accordance with $\omega Ls = \frac{1}{\omega Ccomp}$, where $\omega$ corresponds to an operating frequency of said input signal.

**10.** The attenuator of any preceding claim, wherein said coupling device comprises one of a 3dB coupler and a circulator.

**11.** The attenuator of any preceding claim, wherein said impedance device comprises a lumped impedance device.

**12.** The attenuator of any preceding claim, wherein said variable impedance device comprises one of a transistor and a diode.

**13.** The attenuator of any preceding claim, wherein said variable impedance device comprises one of a field effect transistor and a PIN diode.

**14.** A method, comprising:

providing an input operable to receive an input signal to be attenuated;
providing a coupling device coupled with said input and with an output providing an attenuated input signal; and
providing a pair of reflective loads coupled with said coupling device to receive said input signal, each reflective load comprising a first impedance network arranged in parallel with a second impedance network, said first impedance network and said second impedance network each comprising an impedance device and a variable impedance device.

**Amended claims in accordance with Rule 137(2) EPC.**

**1.** An attenuator, comprising:

an input (10) operable to receive an input signal to be attenuated;
a coupling device (20) coupled with said input and with an output (30) providing an attenuated input signal; and
a pair of reflective loads (40) coupled with said coupling device to receive said input signal, each reflective load comprising a first impedance network (50, 60) arranged in parallel with a second impedance network (70, 80), said first impedance network and said second impedance network each comprising an impedance device and a variable impedance device, wherein interconnecting microstrip lines have a characteristic impedance Z0, said first and second variable impedance devices have an impedance Z, said first impedance device has an impedance jX1 and said second impedance device has an impedance jX2 and an attenuation of said attenuator is maximised when $Z = \pm X1 = \mp X2 = Z0$.

**2.** The attenuator of claim 1, wherein each reflective load is coupled at one end with said coupling device to receive said input signal and at another end with ground.

**3.** The attenuator of claim 1 or 2, wherein said first impedance network and said second impedance network each comprise said impedance device coupled with said coupling device to receive said input signal, said impedance device being coupled with said variable impedance device which is in turn coupled to ground.

**4.** The attenuator of any preceding claim, wherein said first impedance network comprises a series arrangement of a first impedance device (50) and a first variable impedance device (60), and said second impedance network comprises a series arrangement of a second impedance device (70) and a second variable impedance device (80).

**5.** The attenuator of any preceding claim, wherein said first impedance network arranged in parallel with said second impedance network together form a higher-order load and each reflective load comprises a parallel arrangement of 'N' number of said higher-order loads, each in series with a further impedance device, where N = $2^{\wedge(n-1)}$, n≥ 2.

**6.** The attenuator of any preceding claim, wherein a first higher-order load is provided in series with a first further impedance device having an impedance jX1 and a second higher-order load is provided in series with a second further impedance device having an impedance jX2 and an attenuation of said attenuator is maximised when Z = $\pm X1 = \mp X_2 = Z0$.

**7.** The attenuator of any preceding claim, comprising a compensating impedance device provided between each impedance device and variable impedance device.

**8.** The attenuator of claim 7, wherein said variable impedance device has an inductance Ls and said compensating impedance device comprises a capacitor having a capacitance Ccomp determined in accordance with $\omega Ls = \frac{1}{\omega Ccomp}$, where ω corresponds to an operating frequency of said input signal.

**9.** The attenuator of any preceding claim, wherein said coupling device comprises one of a 3dB coupler and a circulator.

**10.** The attenuator of any preceding claim, wherein said impedance device comprises a lumped impedance device.

**11.** The attenuator of any preceding claim, wherein said variable impedance device comprises one of a transistor and a diode.

**12.** The attenuator of any preceding claim, wherein said variable impedance device comprises one of a field effect transistor and a PIN diode.

**13.** A method, comprising:

providing an input (10) operable to receive an input signal to be attenuated;
providing a coupling device (20) coupled with said input and with an output (30) providing an attenuated input signal; and
providing a pair of reflective loads (40) coupled with said coupling device to receive said input signal, each reflective load comprising a first impedance network (50, 60) arranged in parallel with a second impedance network (70, 80), said first impedance network and said second impedance network each comprising an impedance device and a variable impedance device, wherein interconnecting microstrip lines have a characteristic impedance Zo, said first and second variable impedance devices have an impedance Z, said first impedance device has an impedance jX1 and said second impedance device has an impedance jX2 and an attenuation of said attenuator is maximised when Z = $\pm X1 = \mp X2 = Z0$.

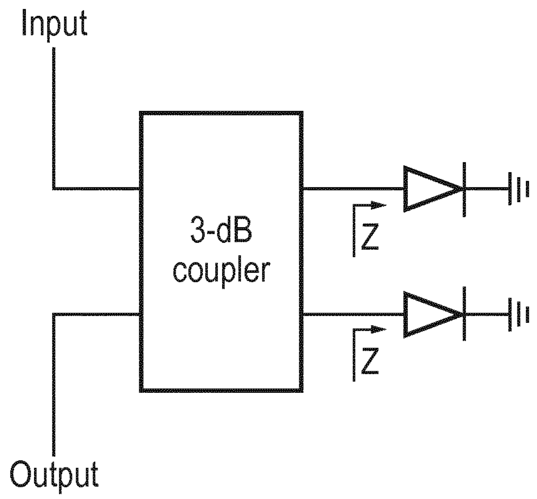


A typical reflection-type attenuator with PIN diodes (bias circuit excluded for brevity)

FIG. 1

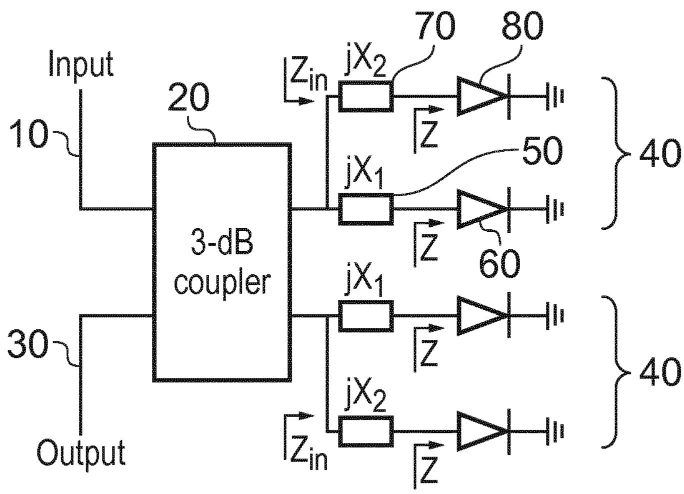


High dynamic range attenuator

FIG. 2

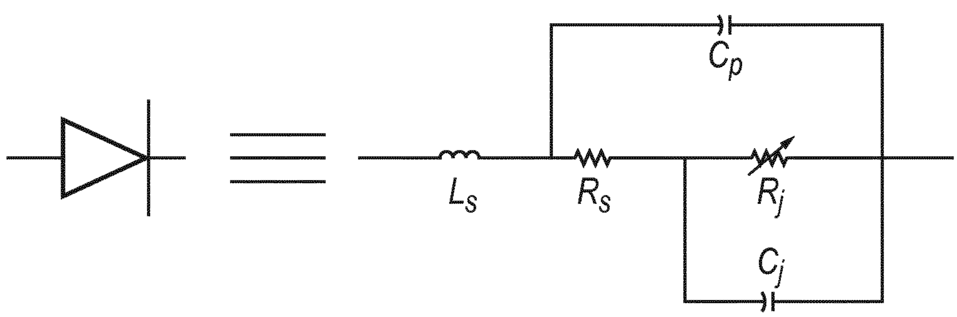


Equivalent circuit of a PIN diode

FIG. 3

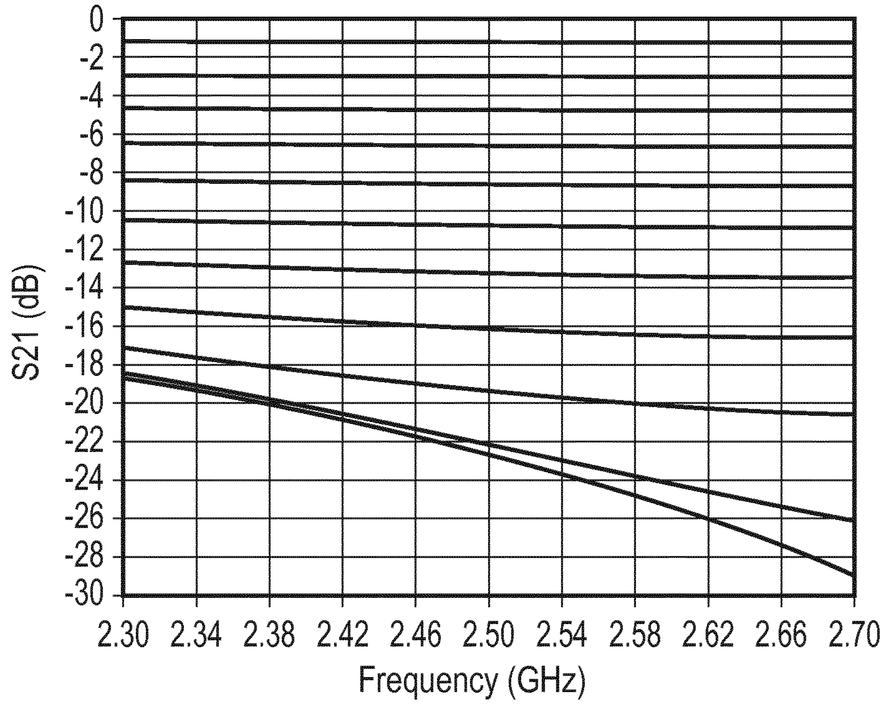


Variation of attenuation of a simple PIN diode based attenuator (junction resistance varies in steps of 5Ω)

FIG. 4

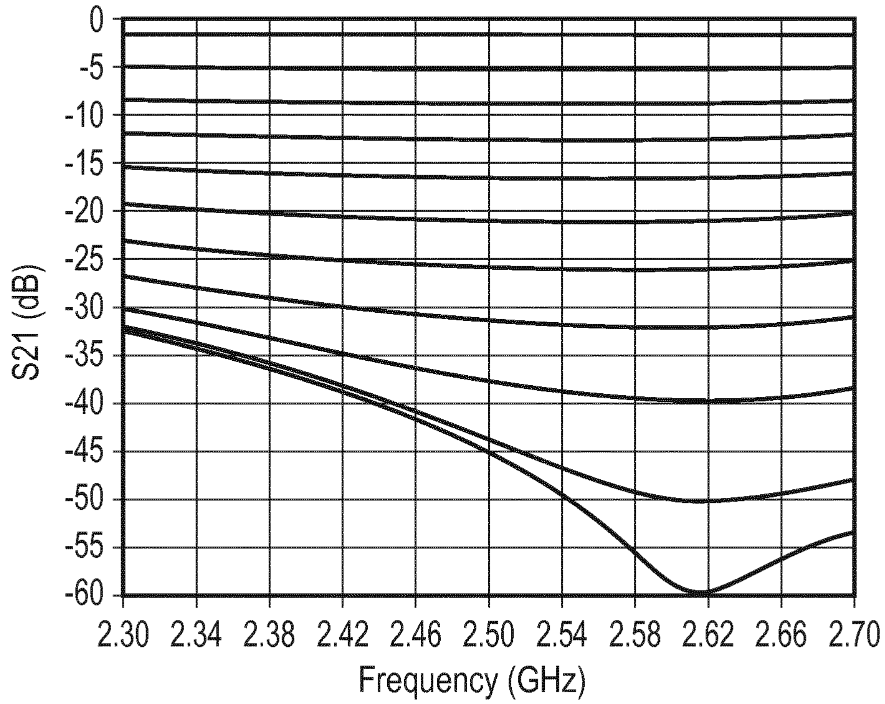


Variation of attenuation of proposed PIN diode based attenuator (junction resistance varies in steps of 5Ω)

FIG. 5

Europäisches Patentamt
European Patent Office
Office européen des brevets

# EUROPEAN SEARCH REPORT

Application Number
EP 14 30 5800

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 276 411 A (WOODIN JR CHARLES E [US] ET AL) 4 January 1994 (1994-01-04)<br>* figures 1-3 *<br>* column 2, lines 5-8 *<br>* column 3, line 57 - column 4, line 12 *<br>----- | 1-14 | INV.<br>H03H7/25 |
| X | BULJA S ET AL: "A New Structure for Reflection-type Phase Shifter with 360/spl deg/ Phase Control Range", RADAR CONFERENCE, 2005. EURAD 2005. EUROPEAN OCT. 6, 2005, PISCATAWAY, NJ, USA,IEEE, 6 October 2005 (2005-10-06), pages 339-342, XP010910885, DOI: 10.1109/EURAD.2005.1605629 ISBN: 978-2-9600551-3-9<br>* figures 1,2 *<br>* page 339, right-hand column, lines 17-19 *<br>----- | 1-14 | |
| X | US 3 769 610 A (SAVARIN A ET AL) 30 October 1973 (1973-10-30)<br>* figure 5 *<br>----- | 1-14 | TECHNICAL FIELDS SEARCHED (IPC)<br>H03H<br>H01P |
| X | US 2011/057746 A1 (YAMAMOTO KAZUYA [JP] ET AL) 10 March 2011 (2011-03-10)<br>* figures 5, 16 *<br>* paragraphs [0055], [0090] - [0092] *<br>----- | 1-14 | |
| X | US 4 902 983 A (FUJIKI YOSHINORI [JP] ET AL) 20 February 1990 (1990-02-20)<br>* figure 2 *<br>----- | 1-14 | |
| X | US 6 255 908 B1 (GHANNOUCHI FADHEL [CA] ET AL) 3 July 2001 (2001-07-03)<br>* figure 4 *<br>-----<br>-/-- | 1-14 | |

The present search report has been drawn up for all claims

2

| Place of search | Date of completion of the search | Examiner |
|---|---|---|
| The Hague | 6 November 2014 | Radomirescu, B-M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 14 30 5800

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 2 693 560 A1 (ALCATEL LUCENT [FR]) 5 February 2014 (2014-02-05) * figure 9 * ----- | 1-14 | |
| A | US 2003/197559 A1 (GHANNOUCHI FADHEL [CA] ET AL) 23 October 2003 (2003-10-23) * figures 2a-2d * ----- | 1-14 | |

TECHNICAL FIELDS SEARCHED (IPC)

The present search report has been drawn up for all claims

2

| Place of search | Date of completion of the search | Examiner |
|---|---|---|
| The Hague | 6 November 2014 | Radomirescu, B-M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................................
& : member of the same patent family, corresponding document

EPO FORM 1503 03.82 (P04C01)

# ANNEX TO THE EUROPEAN SEARCH REPORT ON EUROPEAN PATENT APPLICATION NO. EP 14 30 5800

This annex lists the patent family members relating to the patent documents cited in the above-mentioned European search report. The members are as contained in the European Patent Office EDP file on
The European Patent Office is in no way liable for these particulars which are merely given for the purpose of information.

06-11-2014

| Patent document cited in search report | | Publication date | Patent family member(s) | | | Publication date |
|---|---|---|---|---|---|---|
| US 5276411 | A | 04-01-1994 | NONE | | | |
| US 3769610 | A | 30-10-1973 | CA | 983131 | A1 | 03-02-1976 |
| | | | DE | 2329747 | A1 | 03-01-1974 |
| | | | FR | 2189935 | A1 | 25-01-1974 |
| | | | GB | 1424267 | A | 11-02-1976 |
| | | | JP | S4952551 | A | 22-05-1974 |
| | | | NL | 7308123 | A | 18-12-1973 |
| | | | US | 3769610 | A | 30-10-1973 |
| US 2011057746 | A1 | 10-03-2011 | DE | 102010040290 | A1 | 17-03-2011 |
| | | | JP | 5381528 | B2 | 08-01-2014 |
| | | | JP | 2011061440 | A | 24-03-2011 |
| | | | US | 2011057746 | A1 | 10-03-2011 |
| US 4902983 | A | 20-02-1990 | AU | 605237 | B2 | 10-01-1991 |
| | | | AU | 1119288 | A | 04-08-1988 |
| | | | CA | 1280180 | C | 12-02-1991 |
| | | | DE | 3884635 | D1 | 11-11-1993 |
| | | | DE | 3884635 | T2 | 27-01-1994 |
| | | | EP | 0277636 | A2 | 10-08-1988 |
| | | | US | 4902983 | A | 20-02-1990 |
| US 6255908 | B1 | 03-07-2001 | NONE | | | |
| EP 2693560 | A1 | 05-02-2014 | NONE | | | |
| US 2003197559 | A1 | 23-10-2003 | NONE | | | |

EPO FORM P0459

For more details about this annex : see Official Journal of the European Patent Office, No. 12/82